(19)

**Europäisches Patentamt**

**European Patent Office**

**Office européen des brevets**

(11) **EP 4 079 434 B1**

(12) **EUROPEAN PATENT SPECIFICATION**

(45) Date of publication and mention
of the grant of the patent:
**30.07.2025  Bulletin 2025/31**

(21) Application number: **21194915.1**

(22) Date of filing: **03.09.2021**

(51) International Patent Classification (IPC):
**B23F 21/16** (2006.01)          **G06F 30/17** (2020.01)
**B23F 13/02** (2006.01)

(52) Cooperative Patent Classification (CPC):
**B23F 21/16; B23F 13/02; G06F 30/17**

(54) **METHOD FOR DESIGNING AN ARCHIMEDES WORM GEAR HOB**

VERFAHREN ZUM ENTWURF EINES MIT EINEM ARCHIMEDISCHEN SCHNECKENGETRIEBE AUSGEBILDETEN WÄLZFRÄSENWERKZEUGS

PROCÉDÉ DE CONCEPTION D'UNE FRAISE MÈRE À VIS SANS FIN D'ARCHIMÈDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.04.2021  CN 202110431660**

(43) Date of publication of application:
**26.10.2022  Bulletin 2022/43**

(73) Proprietor: **Chongqing University
Chongqing 400044 (CN)**

(72) Inventors:
• **WANG, Shilong
Chongqing, 400044 (CN)**
• **MA, Chi
Chongqing, 400044 (CN)**
• **WANG, Sibao
Chongqing, 400044 (CN)**
• **HENG, Dechao
Chongqing, 400044 (CN)**
• **ZENG, Lingwan
Chongqing, 400044 (CN)**
• **YANG, Yong
Chongqing, 400044 (CN)**
• **YANG, Canhui
Chongqing, 400044 (CN)**

(74) Representative: **Håmsø Patentbyrå AS**
P.O. Box 9
4068 Stavanger (NO)

(56) References cited:
**EP-A1- 2 480 374      CN-A- 109 376 448
US-A- 1 548 929      US-A- 5 338 134**

• **LAZEBNIK I S: "MINIMIZING TOOTH PROFILE
ERRORS OF HOBS", SOVIET ENGINEERING
RESEARCH, PRA, MELTON MOWBRAY, GB, vol.
10, no. 4, 1 January 1990 (1990-01-01), pages 109
- 111, XP000202873, ISSN: 0144-6622**

EP 4 079 434 B1

**Description**

**TECHNICAL FIELD**

The present disclosure belongs to the technical field of gear hobs, and in particular, to a method for designing an Archimedes worm gear hob.

**BACKGROUND ART**

The application CN109376448A has provided a 3D model method for worm gear hob surface, which establishes a 3D model for the worm gear according parameters of the worm gear and process parameters of the worm gear hob. However, this application does not consider the influence of the design theoretical error of the worm gear and the installation error of the worm gear machine during design of the worm gear hob.

From the conjugate concept between the tooth surface of an Archimedes worm and the tooth surface of an Archimedes worm gear, a certain tooth surface of the worm gear can be cut, provided that a cutting blade of the cutter is located on the mother line of a thread of the worm. That is the principle for machining the worm gear with a double cutter or a quadruple cutter (chasing tool) and a hob, and accuracy of resulting tooth surfaces vary because different cutters are used. To machine the tooth surface of the worm gear, a correct result cannot be achieved, unless a tool similar to the shape of the pairing worm is used and generating machining is performed with engagement parameters completely the same as transmission conditions. Theoretically, the shape of the Archimedes hob is the shape of the Archimedes worm, and the cutting blade of the hob should be located on a thread of the worm. Hence, forming basic parameters of the Archimedes worm is to form basic parameters of the Archimedes worm gear hob. With such characteristics, the Archimedes worm gear hob is designed and computed differently from an ordinary one.

**SUMMARY**

In view of this, an objective of the present invention is to provide a method for designing an Archimedes worm gear hob. By combining with a theoretical design error of the Archimedes worm gear and an installation error of the worm gear machine during design of the worm gear hob, the present invention can effectively improve the accuracy of the machined worm gear.

To achieve the above-mentioned objective, the present disclosure provides the following technical solutions: The present disclosure first provides a method for designing an Archimedes worm gear hob, comprising the following steps:

1) acquiring an error $\varepsilon_{ij}$ between an actual tooth surface and a theoretical tooth surface of an Archimedes worm gear,

as a theoretical tooth thickness of the Archimedes worm gear is different from an actual tooth thickness of a hobbing worm gear, prior to computation of the error $\varepsilon_{ij}$ between the actual tooth surface and the theoretical tooth surface of the Archimedes worm gear, the actual tooth surface rotates an angle relevant to a difference in tooth thickness, such that the actual tooth surface coincides with the theoretical tooth surface at a corresponding grid coordinate point, and thus a following error $\varepsilon_{ij}$ between the actual tooth surface and the theoretical tooth surface of the Archimedes worm gear is obtained:

$$\varepsilon_{ij} = (r_{ij}^{(g)} - r_{ij}^{(gl)}) \cdot n_{ij} \qquad i = 1 \sim m, \, j = 1 \sim n$$

wherein, $r_{ij}^{(g)}$ is a coordinate vector of the actual tooth surface of the Archimedes worm gear at a (i, j)th grid coordinate point; $r_{ij}^{(gl)}$ is a theoretical vector of the actual tooth surface of the Archimedes worm gear at the (i, j)th grid coordinate point; and $n_{ij}$ is a normal vector of the actual tooth surface of the Archimedes worm gear at the (i, j)th grid coordinate point; and

2) correcting a pitch radius increment $d_r$ of the Archimedes worm gear hob according to the error $\varepsilon_{ij}$, and setting:

$$d_r = \frac{\pm 4\Delta \cdot r_{pw}^2}{b_t^2 \sin \alpha_n} \pm \varepsilon_{ij}$$

wherein, $r_{pw}$ is an ideal pitch radius of an Archimedes worm; $b_t$ is a length of a long axis of a contact ellipse at a midpoint; $\alpha_n$ is a transverse modulus of the Archimedes worm gear; and $\Delta$ is a comprehensive deformation coefficient of a material of the Archimedes worm gear hob;

thereby obtaining a diameter increment $\Delta_{os}$ of the Archimedes worm gear hob:

$$\Delta_{os} = (0.01 \sim 0.1) \times d_r$$

correcting, according to the error $\varepsilon_{ij}$ and the diameter increment $\Delta_{os}$, an actual pitch diameter $D_{ph}$ and an actual tip diameter $D_{oh}$ of the Archimedes worm gear hob, respectively comprising:

$$D_{ph} = D_{pw} \pm 2\Delta_{os} \pm \varepsilon_{ij}$$

$$D_{oh} = D_{ph} \pm h_b$$

wherein, $D_{pw}$ is an ideal pitch diameter of the Archimedes worm; $D_{ph}$ is a corrected actual pitch diameter of the Archimedes worm gear hob; $h_b$ is a dedendum of the Archimedes worm gear; and $D_{oh}$ is a corrected actual tip diameter of the Archimedes worm gear hob;

if the actual pitch diameter $D_{ph}$ of the Archimedes worm gear hob is greater than the ideal pitch diameter $D_{pw}$ of the Archimedes worm, then:

$$D_{ph} = D_{pw} + 2\Delta_{os} + \varepsilon_{ij}$$

if the actual pitch diameter $D_{ph}$ of the Archimedes worm gear hob is less than the ideal pitch diameter $D_{pw}$ of the Archimedes worm, then:

$$D_{ph} = D_{pw} - 2\Delta_{os} - \varepsilon_{ij}$$

if the actual tip diameter $D_{oh}$ of the Archimedes worm gear hob is greater than the ideal tip diameter $D_{ph}$ of the Archimedes worm gear hob, then:

$$D_{oh} = D_{ph} + h_b$$

and

if the actual tip diameter $D_{oh}$ of the Archimedes worm gear hob is less than the ideal tip diameter $D_{ph}$ of the Archimedes worm gear hob, then:

$$D_{oh} = D_{ph} - h_b ,$$

and

correcting a pitch lead angle $\lambda_{ph}$ with the corrected actual pitch diameter $D_{ph}$ of the Archimedes worm gear hob:

$$\lambda_{ph} = \arcsin \frac{m_a \pi N_w \cos \lambda_{pw}}{D_{ph}}$$

wherein, $m_a$ is an axial modulus of the Archimedes worm; $N_w$ is the number of threads of the Archimedes worm; and $\lambda_{pw}$ is a pitch lead angle of the Archimedes worm.

Further, letting an expression of a helical tooth surface of the Archimedes hob be $r^{(h)}(u,\theta)$, then the actual tooth surface $r^{(g)}$ of the Archimedes worm gear may be:

$$r^{(g)}(\varphi_g, u, \theta) = L_z(\varphi_g)[L_x(-\frac{\pi}{2}+\delta_t') L_z(-\varphi_h) r^{(h)}(u, \theta) + E_{hg}' \boldsymbol{i}]$$

$$f(\varphi_g, u, \theta) = \boldsymbol{n} \cdot \boldsymbol{v}^{(hg)} = 0$$

$$\varphi_g = \frac{N_g}{N_w} \varphi_h$$

where, $L$ is a 3*3 rotation matrix, and $L$ takes a subscript as a rotation axis and a parameter in a bracket as a rotation angle around the rotation axis; and specifically, $L_z(\varphi_g)$ is a 3*3 rotation matrix rotating an angle of $\varphi_g$ around a z axis;

$$L_x(-\frac{\pi}{2}+\delta_t')$$ is a rotation matrix rotating an angle of $-\frac{\pi}{2}+\delta_t'$ around an x axis; $L_z(-\varphi_h)$ is a 3*3 rotation matrix rotating an angle of $-\varphi_h$ around the z axis; $\varphi_g$ and $\varphi_h$ are the rotation angles of the Archimedes worm gear and the Archimedes hob, respectively; $\delta_t'$ represents an actual installation deviation angle of the Archimedes hob; $E_{hg}'$ represents an actual installation center distance between the worm and the worm gear; $\boldsymbol{i}$ represents a normal vector of a tooth surface of the worm; $(u,\theta)$ is a parameter of the Archimedes helical tooth surface; $\boldsymbol{n}$ is a normal line of the helical tooth surface of the Archimedes hob; $\boldsymbol{v}^{(hg)}$ is a relative velocity between the tooth surfaces of the Archimedes hob and the Archimedes worm gear; and $N_w$ and $N_g$ are the number of threads of the Archimedes worm and the number of teeth of the Archimedes worm gear, respectively; and

letting the diameter increment $\Delta_{os} = 0$ of the Archimedes hob, the installation deviation angle $\delta_t' = 0$ of the Archimedes hob and a machining center distance $E_{hg}' = E_{wg}$, then the theoretical tooth surface $r^{(gl)}$ of the Archimedes worm gear may be obtained; and the tooth surface of the Archimedes worm gear may be gridded into coordinate points, and a formula for selecting $m \times n$ grid coordinate points may be:

$$r^{(g)}(\varphi_g, u, \theta) f(\varphi_g, u, \theta) = \boldsymbol{n} \cdot \boldsymbol{v}^{(hg)} = 0$$

$$z_{ij}^{(g)} - 0.5 F_w' + (i-1)\frac{F_w'}{m-1} = 0 \qquad i = 1 \sim m$$

$$\sqrt{(x_{ij}^h)^2 + (y_{ij}^h)^2} - R_a + (j-1)\frac{h_w}{n-1} = 0 \qquad j = 1 \sim n$$

where, $z_{ij}^{(g)}$ is a coordinate of the tooth surface of the Archimedes worm gear along the rotation axis z; $F_w'$ is an effective face width of the Archimedes worm gear; ($x_{ij}^h$, $y_{ij}^h$) is a coordinate of the Archimedes hob at the (i, j)th grid coordinate point; $R_a$ and $h_w$ are a tip radius and a working depth of the Archimedes worm; and $E_{wg}$ is an ideal installation center distance between the worm and the worm gear.

Further, the comprehensive deformation coefficient $\Delta$ of the material of the worm gear hob may be divided into a piecewise function according to the modulus $m_a$ of the Archimedes worm, specifically:

when the ambient temperature is 20-25°C and the modulus $m_a$ of the Archimedes worm is 1-6 mm, $\Delta = 0.005mm$; when the ambient temperature is 20-25°C and the modulus $m_a$ of the Archimedes worm is 6-12 mm, $\Delta = 0.010mm$; and when the ambient temperature is 20-25°C and the modulus $m_a$ of the Archimedes worm is 12-15 mm, $\Delta = 0.015mm$.

Further, the diameter increment $\Delta_{os}$ of the Archimedes worm gear hob may be divided into a piecewise function according to the modulus $m_a$ of the Archimedes worm, specifically:

when the modulus $m_a$ of the Archimedes worm is 1-6 mm, $\Delta_{os} = (0.01 \sim 0.05) \times d_r$; when the modulus $m_a$ of the Archimedes worm is 6-12 mm, $\Delta_{os} = (0.01 \sim 0.03) \times d_r$; and

when the modulus $m_a$ of the Archimedes worm is 12-15 mm, $\Delta_{os} = (0.04 \sim 0.05) \times d_r$.

The method may further comprise: for configuring a worm gear machine, adjusting, after correcting a parameter of an Archimedes hob with the method for designing an Archimedes worm gear hob, an installation deviation angle $\delta_t^a$ of the Archimedes hob on a worm gear machine as:

$$\delta_t^a = \lambda_{pw} - \lambda_{ph}$$

and

adjusting the worm gear machine such that an actual machining center distance $E_{hg}^a$ between a worm gear and a worm is:

$$E_{hg}^a = E_{wg} + 0.5\Delta_{os}$$

where, $\lambda_{pw}$ is an ideal pitch lead angle of the Archimedes worm; $\lambda_{ph}$ is a corrected pitch lead angle of the Archimedes hob; $E_{wg}$ is an ideal installation center distance between the worm and the worm gear; and $\Delta_{os}$ is a diameter increment of the Archimedes hob.

The present disclosure may have the following beneficial effects:
The Archimedes worm gear machined with the Archimedes hob has an error $\varepsilon_{ij}$ between the actual tooth surface and the ideal tooth surface. The error $\varepsilon_{ij}$ cannot be compensated by the existing Archimedes hob in design stage, and thus affects the accuracy of the machined Archimedes worm gear. The method for designing an Archimedes worm gear hob provided by the present disclosure gives considerations in design to the use of the error $\varepsilon_{ij}$ between the actual tooth surface and the ideal tooth surface of the Archimedes worm gear machined with the Archimedes hob to correct the pitch radius increment $d_r$ of the Archimedes hob to obtain a diameter increment $\Delta_{os}$ of the Archimedes hob, and thus corrects an actual pitch diameter $D_{ph}$, an actual tip diameter $D_{oh}$ and a pitch lead angle $\lambda_{ph}$ of the Archimedes hob. The method can overcome the influence of the error $\varepsilon_{ij}$ on the accuracy of the worm gear machined with the hob, and can effectively improve the accuracy of the worm gear machined with the Archimedes hob.

The method, for configuring a worm gear machine, can adjust an installation deviation angle $\delta_t^a$ and an actual machining center distance $E_{hg}^a$ with corrected parameters of the Archimedes hob, thereby matching with the corrected Archimedes hob, and improving the machining accuracy of the Archimedes worm gear.

The hob after blade grinding can improve the accuracy of gear hobbing and the quality of the tooth surface of the worm gear. Upon the hob after blade grinding, as the relief angle of the top blade and the outer diameter of the hob are reduced, the pitch diameter and the pitch lead angle of the hob also change correspondingly, and the parameters of the worm gear machine should also be adjusted. At this time, there are needs to consider a change of the pitch diameter $D_{ph}'$ of the worm gear hob arising from the blade grinding, a change of the pitch diameter increment $\Delta_{os}'$ of the worm gear hob remained after the blade grinding, and so on, thereby correcting the pitch diameter $D_{ph}'$ and the pitch lead angle $\lambda_{ph}'$ of the Archimedes hob after blade grinding to improve the machining accuracy of the Archimedes hob after blade grinding.

The method, for configuring a worm gear machine upon blade grinding of a hob provided by the present disclosure, can adjust an installation deviation angle $\delta_t^a{}'$ and an actual machining center distance $E_{hg}^a{}'$ with corrected parameters of the Archimedes hob, thereby matching with the Archimedes hob after blade grinding, and improving the machining accuracy of the Archimedes worm gear.

## BRIEF DESCRIPTION OF THE DRAWINGS

In order to make the objectives, technical solutions and beneficial effects of the present disclosure clearer, the present disclosure provides the following accompanying drawing for descriptions:

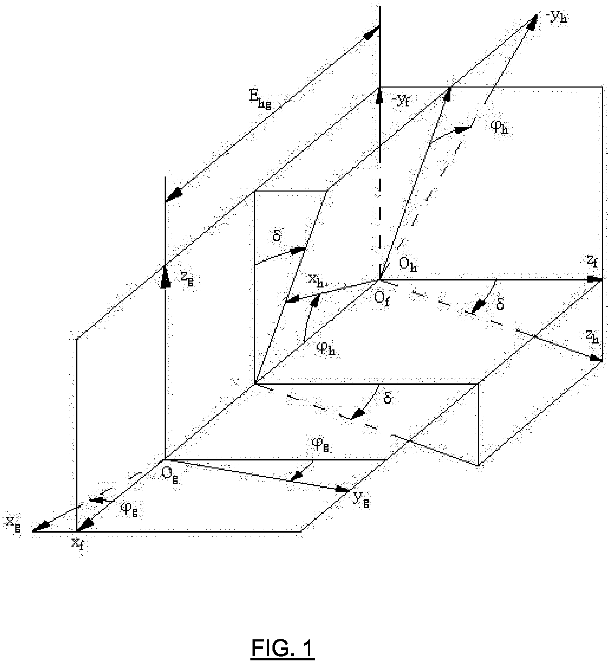

FIGURE 1 is a schematic view of transformation of a coordinate system between an Archimedes hob and an Archimedes worm gear.

## DETAILED DESCRIPTION

The present disclosure will be further described in combination with the accompanying drawing and specific examples, so as to enable those skilled in the art to better understand and practice the present disclosure, but the examples do not constitute any limitation to the present disclosure.

**Example 1**

The example provides a method for designing an Archimedes worm gear hob, including the following steps:

**1) Acquire an error $\varepsilon_{ij}$ between an actual tooth surface and a theoretical tooth surface of an Archimedes worm gear.**

Specifically, the method for acquiring the error $\varepsilon_{ij}$ is as follows:
As the cut tooth surface of the Archimedes worm gear is an enveloping surface of the helical tooth surface of the hob, let an expression of the helical tooth surface of the Archimedes hob be $r^{(h)}(u,\theta)$, where $(u,\theta)$ is a parameter of the Archimedes helical tooth surface. Referring to coordinate transformation in FIG. 1, the actual tooth surface $r^{(g)}$ of the Archimedes worm gear is:

$$\boldsymbol{r}^{(g)}(\varphi_g, u, \theta) = \boldsymbol{L}_z(\varphi_g)[\boldsymbol{L}_x(-\frac{\pi}{2}+\delta_t')\boldsymbol{L}_z(-\varphi_h)\boldsymbol{r}^{(h)}(u,\theta) + E_{hg}'\boldsymbol{i}]$$

$$f(\varphi_g, u, \theta) = \boldsymbol{n} \cdot \boldsymbol{v}^{(hg)} = 0$$

$$\varphi_g = \frac{N_g}{N_w}\varphi_h$$

where, $\boldsymbol{L}$ is a 3*3 rotation matrix, and $\boldsymbol{L}$ takes a subscript as a rotation axis and a parameter in a bracket as a rotation angle around the rotation axis; and specifically, $\boldsymbol{L}_z(\varphi_g)$ is a 3*3 rotation matrix rotating an angle of $\varphi_g$ around a z axis; $\boldsymbol{L}_x(-\frac{\pi}{2}+\delta_t')$ is a rotation matrix rotating an angle of $-\frac{\pi}{2}+\delta_t'$ around an x axis; $\boldsymbol{L}_z(-\varphi_h)$ is a 3*3 rotation matrix rotating an angle of $-\varphi_h$ around the z axis; $\varphi_g$ and $\varphi_h$ are the rotation angles of the Archimedes worm gear and the Archimedes hob, respectively; $\delta_t'$ represents an actual installation deviation angle of the Archimedes hob; $E_{hg}'$ represents an actual installation center distance between the worm and the worm gear; $\boldsymbol{i}$ represents a normal vector of a tooth surface of the worm; $(u,\theta)$ is a parameter of the Archimedes helical tooth surface; $\boldsymbol{n}$ is a normal line of the helical tooth surface of the Archimedes hob; $\boldsymbol{v}^{(hg)}$ is a relative velocity between the Archimedes hob and the tooth surface of the Archimedes worm gear; and $N_w$ and $N_g$ are the number of threads of the Archimedes worm and the number of teeth of the Archimedes worm gear, respectively.

The actual tooth surface $r^{(g)}$ of the Archimedes worm gear involves 4 parameters ($\varphi_g, \varphi_h, u, \theta$) and 2 constraint equations, and thus is indicated as the equation containing two independent parameters for the tooth surface of the worm gear.

Let the diameter increment $\Delta_{os} = 0$ of the Archimedes hob, the installation deviation angle $\delta_t' = 0$ of the Archimedes hob and a machining center distance $E_{hg}' = E_{wg}$, then the theoretical tooth surface $r^{(gl)}$ of the Archimedes worm gear may be obtained; and the tooth surface of the Archimedes worm gear are gridded into coordinate points, and a formula for selecting $m \times n$ grid coordinate points is:

$$\boldsymbol{r}^{(g)}(\varphi_g, u, \theta)f(\varphi_g, u, \theta) = \boldsymbol{n} \cdot \boldsymbol{v}^{(hg)} = 0$$

$$z_{ij}^{(g)} - 0.5F_w' + (i-1)\frac{F_w'}{m-1} = 0 \qquad i = 1 \sim m$$

$$\sqrt{(x_{ij}^h)^2 + (y_{ij}^h)^2} - R_a + (j-1)\frac{h_w}{n-1} = 0 \qquad j = 1 \sim n$$

where, $z_{ij}^{(g)}$ is a coordinate of the tooth surface of the Archimedes worm gear along the rotation axis z; $F_w{}'$ is an effective face width of the Archimedes worm gear; ($x_{ij}^h$, $y_{ij}^h$) is a coordinate of the Archimedes hob at a (i, j)th grid coordinate point; $R_a$ and $h_w$ are a tip radius and a working depth of the Archimedes worm; and $E_{wg}$ is an ideal installation center distance between the worm and the worm gear.

As a theoretical tooth thickness of the Archimedes worm gear is different from an actual tooth thickness of a hobbing worm gear, prior to computation of the error $\varepsilon_{ij}$ between the actual tooth surface and the theoretical tooth surface of the Archimedes worm gear, the actual tooth surface rotates an angle relevant to a difference in tooth thickness, such that the actual tooth surface coincides with the theoretical tooth surface at a corresponding grid coordinate point, and thus a following error $\varepsilon_{ij}$ between the actual tooth surface and the theoretical tooth surface of the Archimedes worm gear may be obtained:

$$\varepsilon_{ij} = (r_{ij}^{(g)} - r_{ij}^{(gl)}) \cdot n_{ij} \qquad i = 1 \sim m, j = 1 \sim n$$

where, $r_{ij}^{(g)}$ is a coordinate vector of the actual tooth surface of the Archimedes worm gear at the (i, j)th grid coordinate point; $r_{ij}^{(gl)}$ is a theoretical vector of the actual tooth surface of the Archimedes worm gear at the (i, j)th grid coordinate point; and $n_{ij}$ is a normal vector of the actual tooth surface of the Archimedes worm gear at the (i, j)th grid coordinate point.

Therefore, the error in the tooth surface of the Archimedes worm gear in an ideal condition, i.e., the error in the tooth surface of the Archimedes worm gear in the case of the diameter increment $\Delta_{os} = 0$ of the Archimedes hob, the installation deviation angle $\delta_t{}' = 0$ of the Archimedes hob, and the machining center distance $E_{hg}{}' = E_{wg}$, is obtained. However, during actual machining of the Archimedes worm gear, there exist the diameter increment $\Delta_{os} \neq 0$ of the Archimedes hob, the installation deviation angle $\delta_t{}' \neq 0$ of the Archimedes hob, and the machining center distance $E_{hg}{}' \neq E_{wg}$ due to the installation error of the worm gear machine, which leads to the error in the tooth surface of the Archimedes worm gear inevitably.

**2) Correct a parameter of an Archimedes hob.**

21) Correct a pitch radius increment $d_r$ of the Archimedes hob. Specifically, the pitch radius increment $d_r$ of the conventional Archimedes hob is expressed as:

$$d_r = \frac{8\Delta \cdot r_1^2}{b_t^2 \sin \alpha_n}$$

As the pitch radius increment $d_r$ of the conventional hob only considers the increase of the pitch radius increment $d_r$ of the hob, the computation on the pitch radius increment $d_r$ of the hob is inaccurate.

In the example, the pitch radius increment $d_r$ of the Archimedes hob is corrected according to the error $\varepsilon_{ij}$, and:

$$d_r = \frac{\pm 4\Delta \cdot r_1^2}{b_t^2 \sin \alpha_n} \pm \varepsilon_{ij}$$

where, $r_1$ is an ideal pitch radius of the Archimedes worm; $b_t$ is a length of a long axis of a contact ellipse at a midpoint; $\alpha_n$ is a transverse modulus of the Archimedes worm gear; and $\Delta$ is a comprehensive deformation coefficient of a material of the Archimedes hob.

In the example, the comprehensive deformation coefficient $\Delta$ of the material of the worm gear hob is divided into a piecewise function according to a modulus $m_a$ of the Archimedes worm, specifically:

when the ambient temperature is 20-25°C and the modulus $m_a$ of the Archimedes worm is 1-6 mm, $\Delta = 0.005mm$;
when the ambient temperature is 20-25°C and the modulus $m_a$ of the Archimedes worm is 6-12 mm, $\Delta = 0.010mm$; and

when the ambient temperature is 20-25°C and the modulus $m_a$ of the Archimedes worm is 12-15 mm, $\Delta = 0.015mm$.

22) Correct a diameter increment $\Delta_{os}$ of the Archimedes hob.

The formula for computing the diameter increment $\Delta_{os}$ of each of conventional single-thread and double-thread Archimedes worm gear hobs is:

$$\Delta_{os} = 1.7056 + 0.3653m_a$$

The formula for computing the diameter increment of each of conventional triple-thread to hexa-thread Archimedes worm gear hobs is:

$$\Delta_{os} = 1.31708 + 0.347744m_a$$

In the prior art, $\Delta_{os}$ is also set as 5% of the modulus $m_a$ of the Archimedes worm, i.e., the diameter increment $\Delta_{os}$ of the Archimedes worm gear hob is:

$$\Delta_{os} = 5\%m_a$$

The existing methods for correcting the diameter increment $\Delta_{os}$ of the Archimedes worm gear hob use an empirical value and have the significant error. Such an error is more particularly obvious in the case of the larger the modulus $m_a$ of the Archimedes worm.

In the example, the diameter increment $\Delta_{os}$ of the Archimedes hob is corrected according to the corrected pitch radius increment $d_r$ of the Archimedes hob, i.e.:

$$\Delta_{os} = (0.01 \sim 0.1) \times d_r$$

Specifically, in the example, the diameter increment $\Delta_{os}$ of the Archimedes worm gear hob is divided into a piecewise function according to the modulus $m_a$ of the Archimedes worm, specifically:

when the modulus $m_a$ of the Archimedes worm is 1-6 mm, $\Delta_{os} = (0.01 \sim 0.05) \times d_r$;
when the modulus $m_a$ of the Archimedes worm is 6-12 mm, $\Delta_{os} = (0.01 \sim 0.03) \times d_r$; and
when the modulus $m_a$ of the Archimedes worm is 12-15 mm, $\Delta_{os} = (0.04 \sim 0.05) \times d_r$.

23) **Correct an actual pitch diameter $D_{ph}$ and an actual tip diameter $D_{oh}$ of the Archimedes hob.**

In the example, the actual pitch diameter $D_{ph}$ and the actual tip diameter $D_{oh}$ of the Archimedes hob are corrected according to the error $\varepsilon_{ij}$ and the corrected diameter increment $\Delta_{os}$, respectively including:

$$D_{ph} = D_{pw} \pm 2\Delta_{os} \pm \varepsilon_{ij}$$

$$D_{oh} = D_{ph} \pm h_b$$

where, $D_{pw}$ is an ideal pitch diameter of the Archimedes worm; $D_{ph}$ is a corrected actual pitch diameter of the Archimedes hob; $h_b$ is a dedendum of the Archimedes worm gear; and $D_{oh}$ is a corrected actual tip diameter of the Archimedes hob;

if the actual pitch diameter $D_{ph}$ of the Archimedes hob is greater than the ideal pitch diameter $D_{pw}$ of the Archimedes worm, then:

$$D_{ph} = D_{pw} + 2\Delta_{os} + \varepsilon_{ij}$$

if the actual pitch diameter $D_{ph}$ of the Archimedes hob is less than the ideal pitch diameter $D_{pw}$ of the Archimedes worm, then:

$$D_{ph} = D_{pw} - 2\Delta_{os} - \varepsilon_{ij}$$

if the actual tip diameter $D_{oh}$ of the Archimedes hob is greater than the ideal tip diameter $D_{ph}$ of the Archimedes hob, then:

$$D_{oh} = D_{ph} + h_b$$

and

if the actual tip diameter $D_{oh}$ of the Archimedes hob is less than the ideal tip diameter $D_{ph}$ of the Archimedes hob, then:

$$D_{oh} = D_{ph} - h_b$$

**24) Correct a pitch lead angle $\lambda_{ph}$**

On the pitch joint, the normal lead $H_{hn}$ of the hob equals to the normal lead $H_{wn}$ of the worm, i.e., $H_{hn} = H_{wn}$. According to the definition of the axial lead $H$ and the relation with the normal lead:

$$H = D_p \pi \tan \lambda_p$$

$$H = m_a \pi N_w$$

$$H_w = H \cos \lambda_p$$

where, $m_a$ is an axial modulus of the Archimedes worm.
Hence:

$$D_{ph} \pi \tan \lambda_{ph} \cos \lambda_{ph} = D_{pw} \pi \tan \lambda_{pw} \cos \lambda_{pw} = m_a \pi N_w \cos \lambda_{pw}$$

i.e.,:

$$D_{ph} \pi \tan \lambda_{ph} \cos \lambda_{ph} = D_{pw} \pi \tan \lambda_{pw} \cos \lambda_{pw}$$

also i.e.,:

$$D_{ph} \sin \lambda_{ph} = D_{pw} \sin \lambda_{pw}$$

The pitch lead angle $\lambda_{ph}$ of the Archimedes hob may be obtained:

$$\lambda_{ph} = \arcsin \frac{m_a \pi N_w \cos \lambda_{pw}}{D_{ph}}$$

The corrected pitch lead angle $\lambda_{ph}$ of the Archimedes hob is obtained according to the corrected actual pitch diameter $D_{ph}$ of the Archimedes hob:

$$\lambda_{ph} = \arcsin \frac{m_a \pi N_w \cos \lambda_{pw}}{D_{pw} \pm 2\Delta_{os} \pm \varepsilon_{ij}}$$

where, $m_a$ is the axial modulus of the Archimedes worm; $N_w$ is the number of threads of the Archimedes worm; and $\lambda_{pw}$ is a pitch lead angle of the Archimedes worm.

Example 2

As can be seen from Example 1, due to the installation deviation angle $\delta_t' \neq 0$ of the Archimedes hob and the machining center distance $E_{hg}' \neq E_{wg}$, there is a need to correct configurations of the worm gear machine, and an urgent need to adjust installation parameters of the worm gear machine.

Specifically, a method for configuring a worm gear machine in the example adjusts, after correcting a parameter of an Archimedes hob with the method for designing an Archimedes worm gear hob, an installation deviation angle $\delta_t^a$ of the Archimedes hob on a worm gear machine as:

$$\delta_t^a = \lambda_{pw} - \lambda_{ph}$$

and

adjusts the worm gear machine such that an actual machining center distance $E_{hg}^a$ between a worm gear and a worm is:

$$E_{hg}^a = E_{wg} + 0.5\Delta_{os}$$

where, $\lambda_{pw}$ is an ideal pitch lead angle of the Archimedes worm; $\lambda_{ph}$ is a corrected pitch lead angle of the Archimedes hob; $E_{wg}$ is an ideal installation center distance between the worm and the worm gear; and $\Delta_{os}$ is a diameter increment of the Archimedes hob.

**Example 3**

The hob after blade grinding can improve the accuracy of gear hobbing and the quality of the toothed surface of the worm gear. Therefore, a blade grinding manner is typically used to improve the accuracy of gear hobbing and the quality of the toothed surface of the worm gear. Upon the blade grinding of the hob, as the relief angle of the top blade and the outer diameter of the hob are reduced, the pitch diameter and the pitch lead angle of the hob also change correspondingly, and parameters of the machine tool are also adjusted necessarily. At this time, there are needs to consider a change of the pitch diameter $D_{ph}'$ of the worm gear hob arising from the blade grinding, a change of the pitch diameter increment $\Delta_{os}'$ of the worm gear hob remained after the blade grinding, and so on.

Specifically, a method for correcting an Archimedes worm gear hob by blade grinding in the example includes the following steps:

1) Acquire an error $\varepsilon_{ij}$ between an actual tooth surface and a theoretical tooth surface of an Archimedes worm gear. The method for acquiring the error $\varepsilon_{ij}$ in the example is the same as Example 1, and will not be repeated one after another.

2) Correct and measure a parameter of an Archimedes hob after blade grinding

**21) Correct a pitch diameter $D_{ph}'$ of the Archimedes hob after blade grinding**

The pitch diameter $D_{ph}'$ of the conventional worm gear hob after blade grinding is

$$D_{ph}' = D_{oh}' - 2 \times h_b$$

where, an outer diameter $D_{oh}'$ of the hob after blade grinding may be acquired by measurement.

Neither the modulus $m_a$ of the Archimedes worm, nor the error $\varepsilon_{ij}$ between the theoretical and actual tooth surfaces of the Archimedes worm gear is considered during correction of the pitch diameter $D_{ph}'$ of the conventional hob after blade grinding, which results in that the computed pitch diameter $D_{ph}'$ of the hob after blade grinding is small.

In the example, the outer diameter $D_{oh}'$ of the Archimedes hob after blade grinding is measured, and the pitch diameter $D_{ph}'$ of the Archimedes hob after blade grinding is corrected, to obtain:

$$D_{ph}' = D_{oh}' - (1 \sim 2) \times h_b \pm \varepsilon_{ij}$$

where, $h_b$ is a dedendum of the Archimedes worm gear.

Specifically, in the example, the pitch diameter $D_{ph}'$ of the Archimedes hob after blade grinding is divided into a piecewise function according to a modulus $m_a$ of the Archimedes worm, specifically:

when the modulus $m_a$ of the Archimedes worm is 1-6 mm, $D_{ph}' = D_{oh}' - h_b$;
when the modulus $m_a$ of the Archimedes worm is 6-12 mm, $D_{ph}' = D_{oh}' - 1.5h_b$; and
when the modulus $m_a$ of the Archimedes worm is 12-15 mm, $D_{ph}' = D_{oh}' - 2h_b$.

**22) Correct a pitch diameter increment $\Delta_{os}'$ of the Archimedes hob after blade grinding**

In the example, the pitch diameter increment $\Delta_{os}'$ of the Archimedes hob after blade grinding is:

$$\Delta_{os}' = D_{ph}' - (0.5 \sim 1)D_{pw}$$

where, $D_{pw}$ is an ideal pitch diameter of an Archimedes worm.

Specifically, in the example, the pitch diameter increment $\Delta_{os}'$ of the Archimedes hob after blade grinding is divided into a piecewise function according to the modulus $m_a$ of the Archimedes worm, specifically:

when the modulus $m_a$ of the Archimedes worm is 1-6 mm, $\Delta_{os}' = D_{ph}' - 0.5D_{pw}$;
when the modulus $m_a$ of the Archimedes worm is 6-12 mm, $\Delta_{os}' = D_{ph}' - 0.75D_{pw}$; and
when the modulus $m_a$ of the Archimedes worm is 12-15 mm, $\Delta_{os}' = D_{ph}' - D_{pw}$.

**23) Correct a pitch lead angle $\lambda_{ph}'$ of the Archimedes hob after blade grinding**

Owing to the equal axial lead of the hob, the following may be obtained:

$$D_{ph}\pi \tan \lambda_{ph} \cos \lambda_{ph} = D_{pw}\pi \tan \lambda_{pw} \cos \lambda_{pw} = m_a \pi N_w \cos \lambda_{pw}$$

$$D_{ph}' \tan \lambda_{ph}' = D_{ph} \tan \lambda_{ph}$$

Hence, the pitch lead angle $\lambda_{ph}'$ of the Archimedes hob after blade grinding may be obtained:

$$\lambda_{ph}' = \arctan \frac{D_{pw} \sin \lambda_{pw}}{D_{ph}' \cos(\lambda_{pw} - \delta_t)}$$

where, $\lambda_{pw}$ is a pitch lead angle of the Archimedes worm; and $\delta_t$ is an original installation deviation angle of the Archimedes hob.

The pitch lead angle $\lambda_{ph}'$ of the Archimedes hob after blade grinding may be corrected with the corrected pitch diameter $D_{ph}'$ of the Archimedes hob after blade grinding.

**Example 4**

Due to changes of the parameters of the Archimedes hob after blade grinding, installation parameters of a worm gear mold need to be correspondingly adjusted. Specifically, a method for configuring a worm gear machine upon blade grinding of a hob in the example adjusts, after correcting a parameter of an Archimedes hob with the method for correcting an Archimedes worm gear hob by blade grinding, an installation deviation angle $\delta_t^{a}{}'$ and an actual machining center distance $E_{hg}^{a}{}'$ of the Archimedes hob on a worm gear machine as:

$$\delta_t^{a}{}' = \lambda_{pw} - \lambda_{ph}'$$

$$E_{hg}^{a}\,' = E_{wg} + 0.5\Delta_{os}\,'$$

where, $\lambda_{pw}$ is a pitch lead angle of an Archimedes worm; $\lambda_{ph}$' is a pitch lead angle of an Archimedes hob after blade grinding; $E_{wg}$ is an ideal installation center distance between the worm and a worm gear; and $\Delta_{os}$' is a pitch diameter increment of the Archimedes hob after blade grinding.

In addition, those skilled in the art should know that when the Archimedes hob is designed, there are further the following basic parameters to be determined: the number $z_1$ of threads of the worm, the number $z_2$ of teeth of the worm gear, the modulus $m$, the pressure angle $\alpha$, the diameter $d_1$ of a reference circle of the worm, the helix angle $\gamma$ and the face width $b$; and parameters computed with the basic parameters include: the pitch $p$ of the worm, the transmission ratio $i_{21}$, the center distance $A_0$, the diameter $d_{a1}$ of an addendum circle of the worm, the diameter $d_{f1}$ of a dedendum circle of the worm, and so on.

The above examples are merely preferred examples provided to more fully illustrate the present disclosure, and the scope of the present disclosure is not limited thereto. Equivalent substitutions or alternations made by those skilled in the art on the basis of the present disclosure are all within the protection scope of the present disclosure. The protection scope of the present disclosure is subject to the claims.

## Claims

1. A method for designing an Archimedes worm gear hob, comprising the following steps:

    1) acquiring an error $\varepsilon_{ij}$ between an actual tooth surface and a theoretical tooth surface of an Archimedes worm gear,

    as a theoretical tooth thickness of the Archimedes worm gear is different from an actual tooth thickness of a hobbing worm gear, prior to computation of the error $\varepsilon_{ij}$ between the actual tooth surface and the theoretical tooth surface of the Archimedes worm gear, the actual tooth surface rotates an angle relevant to a difference in tooth thickness, such that the actual tooth surface coincides with the theoretical tooth surface at a corresponding grid coordinate point, and thus a following error $\varepsilon_{ij}$ between the actual tooth surface and the theoretical tooth surface of the Archimedes worm gear is obtained:

    $$\varepsilon_{ij} = (r_{ij}^{(g)} - r_{ij}^{(gl)}) \cdot n_{ij} \qquad i = 1 \sim m, j = 1 \sim n$$

    wherein, $r_{ij}^{(g)}$ is a coordinate vector of the actual tooth surface of the Archimedes worm gear at a (i, j)th grid coordinate point; $r_{ij}^{(gl)}$ is a theoretical vector of the actual tooth surface of the Archimedes worm gear at the (i, j)th grid coordinate point; and $n_{ij}$ is a normal vector of the actual tooth surface of the Archimedes worm gear at the (i, j)th grid coordinate point; and

    2) correcting a pitch radius increment $d_r$ of the Archimedes worm gear hob according to the error $\varepsilon_{ij}$, and setting:

    $$d_r = \frac{\pm 4\Delta \cdot r_{pw}^{2}}{b_t^{2} \sin \alpha_n} \pm \varepsilon_{ij}$$

    wherein, $r_{pw}$ is an ideal pitch radius of an Archimedes worm; $b_t$ is a length of a long axis of a contact ellipse at a midpoint; $\alpha_n$ is a transverse modulus of the Archimedes worm gear; and $\Delta$ is a comprehensive deformation coefficient of a material of the Archimedes worm gear hob;
    thereby obtaining a diameter increment $\Delta_{os}$ of the Archimedes worm gear hob:

    $$\Delta_{os} = (0.01 \sim 0.1) \times d_r$$

    correcting, according to the error $\varepsilon_{ij}$ and the diameter increment $\Delta_{os}$, an actual pitch diameter $D_{ph}$ and an actual tip diameter $D_{oh}$ of the Archimedes worm gear hob, respectively comprising:

$$D_{ph} = D_{pw} \pm 2\Delta_{os} \pm \varepsilon_{ij}$$

$$D_{oh} = D_{ph} \pm h_b$$

wherein, $D_{pw}$ is an ideal pitch diameter of the Archimedes worm; $D_{ph}$ is a corrected actual pitch diameter of the Archimedes worm gear hob; $h_b$ is a dedendum of the Archimedes worm gear; and $D_{oh}$ is a corrected actual tip diameter of the Archimedes worm gear hob;
if the actual pitch diameter $D_{ph}$ of the Archimedes worm gear hob is greater than the ideal pitch diameter $D_{pw}$ of the Archimedes worm, then:

$$D_{ph} = D_{pw} + 2\Delta_{os} + \varepsilon_{ij}$$

if the actual pitch diameter $D_{ph}$ of the Archimedes worm gear hob is less than the ideal pitch diameter $D_{pw}$ of the Archimedes worm, then:

$$D_{ph} = D_{pw}\text{-}2\Delta_{os}\text{-}\varepsilon_{ij}$$

if the actual tip diameter $D_{oh}$ of the Archimedes worm gear hob is greater than the ideal tip diameter $D_{ph}$ of the Archimedes worm gear hob, then:

$$D_{oh} = D_{ph}+h_b$$

and
if the actual tip diameter $D_{oh}$ of the Archimedes worm gear hob is less than the ideal tip diameter $D_{ph}$ of the Archimedes worm gear hob, then:

$$D_{oh} = D_{ph}\text{-}h_b \; ;$$

and
correcting a pitch lead angle $\lambda_{ph}$ with the corrected actual pitch diameter $D_{ph}$ of the Archimedes worm gear hob:

$$\lambda_{ph} = \arcsin \frac{m_a \pi N_w \cos \lambda_{pw}}{D_{ph}}$$

wherein, $m_a$ is an axial modulus of the Archimedes worm; $N_w$ is the number of threads of the Archimedes worm; and $\lambda_{pw}$ is a pitch lead angle of the Archimedes worm.

2. The method according to claim 1, wherein letting an expression of a helical tooth surface of the Archimedes worm gear hob be $r^{(h)}(u,\theta)$, then the actual tooth surface $r^{(g)}$ of the Archimedes worm gear is:

$$r^{(g)}(\varphi_g,u,\theta) = L_z(\varphi_g)[L_x(-\frac{\pi}{2}+\delta_t\,')L_z(-\varphi_h)r^{(h)}(u,\theta)+E_{hg}\,'i]$$

$$f(\varphi_g,u,\theta) = n \cdot v^{(hg)} = 0$$

$$\varphi_g = \frac{N_g}{N_w}\varphi_h$$

wherein, $L$ is a 3*3 rotation matrix, and $L$ takes a subscript as a rotation axis and a parameter in a bracket as a rotation angle around the rotation axis; and specifically, $L_z(\varphi_g)$ is a 3*3 rotation matrix rotating an angle of $\varphi_g$

$$L_x(-\frac{\pi}{2}+\delta_t')$$

around a z axis; $\qquad$ is a rotation matrix rotating an angle of $\quad -\frac{\pi}{2}+\delta_t'$ around an x axis; $L_z(-\varphi_h)$ is a 3*3 rotation matrix rotating an angle of $-\varphi_h$ around the z axis; $\varphi_g$ and $\varphi_h$ are respectively a rotation angle of the Archimedes worm gear and the Archimedes worm gear hob; $\delta_t'$ represents an actual installation deviation angle of the Archimedes worm gear hob; $E_{hg}'$ represents an actual installation center distance between the worm and the worm gear; $i$ represents a normal vector of a tooth surface of the worm; $(u,\theta)$ is a parameter of the Archimedes helical tooth surface; $n$ is a normal line of the helical tooth surface of the Archimedes worm gear hob; $v^{(hg)}$ is a relative velocity between the Archimedes worm gear hob and the tooth surface of the Archimedes worm gear; and $N_w$ and $N_g$ are respectively the number of threads of the Archimedes worm and the number of teeth of the Archimedes worm gear; and

letting the diameter increment $\Delta_{os} = 0$ of the Archimedes worm gear hob, the installation deviation angle $\delta_t' = 0$ of the Archimedes worm gear hob and a machining center distance $E_{hg}' = E_{wg}$, then the theoretical tooth surface $r^{(gl)}$ of the Archimedes worm gear is obtained; and the tooth surface of the Archimedes worm gear are gridded into coordinate points, and a formula for selecting $m \times n$ grid coordinate points is:

$$r^{(g)}(\varphi_g, u, \theta) f(\varphi_g, u, \theta) = n \cdot v^{(hg)} = 0$$

$$z_{ij}^{(g)} - 0.5 F_w' + (i-1)\frac{F_w'}{m-1} = 0 \qquad i = 1 \sim m$$

$$\sqrt{(x_{ij}^h)^2 + (y_{ij}^h)^2} - R_a + (j-1)\frac{h_w}{n-1} = 0 \qquad j = 1 \sim n$$

wherein, $z_{ij}^{(g)}$ is a coordinate of the tooth surface of the Archimedes worm gear along the rotation axis z; $F_w'$ is an effective face width of the Archimedes worm gear; ( $x_{ij}^h$, $y_{ij}^h$ ) is a coordinate of the Archimedes worm gear hob at the (i, j)th grid coordinate point; $R_a$ and $h_w$ are a tip radius and a working depth of the Archimedes worm; and $E_{wg}$ is an ideal installation center distance between the worm and the worm gear.

3. The method according to claim 1 or 2, wherein the comprehensive deformation coefficient $\Delta$ of the material of the Archimedes worm gear hob is divided into a piecewise function according to the modulus $m_a$ of the Archimedes worm, specifically:

when the ambient temperature is 20-25°C and the modulus $m_a$ of the Archimedes worm is 1-6 mm, $\Delta = 0.005mm$;
when the ambient temperature is 20-25°C and the modulus $m_a$ of the Archimedes worm is 6-12 mm, $\Delta = 0.010mm$ ; and
when the ambient temperature is 20-25°C and the modulus $m_a$ of the Archimedes worm is 12-15 mm, $\Delta = 0.015mm$.

4. The method according to any preceding claim, wherein the diameter increment $\Delta_{os}$ of the Archimedes worm gear hob is divided into a piecewise function according to the modulus $m_a$ of the Archimedes worm, specifically:

when the modulus $m_a$ of the Archimedes worm is 1-6 mm, $\Delta_{os} = (0.01 \sim 0.02) \times d_r$;
when the modulus $m_a$ of the Archimedes worm is 6-12 mm, $\Delta_{os} = (0.01 \sim 0.03) \times d_r$; and
when the modulus $m_a$ of the Archimedes worm is 12-15 mm, $\Delta_{os} = (0.04 \sim 0.05) \times d_r$.

5. The method according to any preceding claim, further comprising: for configuring a worm gear machine, adjusting an installation deviation angle $\delta_t^a$ of the Archimedes hob on a worm gear machine as:

$$\delta_t^a = \lambda_{pw} - \lambda_{ph}$$

and

adjusting the worm gear machine such that an actual machining center distance $E_{hg}^{a}$ between a worm gear and a worm is:

$$E_{hg}^{a} = E_{wg} + 0.5\Delta_{os}$$

wherein, $\lambda_{pw}$ is an ideal pitch lead angle of the Archimedes worm; $\lambda_{ph}$ is a corrected pitch lead angle of the Archimedes worm gear hob; $E_{wg}$ is an ideal installation center distance between the worm and the worm gear; and $\Delta_{os}$ is a diameter increment of the Archimedes worm gear hob.

**Patentansprüche**

1. **Verfahren** zum Entwurf eines mit einem archimedischen Schneckengetriebe ausgebildeten Wälzfräsenwerkzeugs, umfassend die folgenden Schritte:

1) Erlangen eines Fehlers $\varepsilon_{ij}$ zwischen einer tatsächlichen Zahnoberfläche und einer theoretischen Zahnoberfläche eines archimedischen Schneckengetriebes,

wobei, da eine theoretische Zahndicke des archimedischen Schneckengetriebes von einer tatsächlichen Zahndicke eines Wälzfrässchneckengetriebes verschieden ist, vor einer Berechnung des Fehlers $\varepsilon_{ij}$ zwischen der tatsächlichen Zahnoberfläche und der theoretischen Zahnoberfläche des archimedischen Schneckengetriebes, die tatsächliche Zahnoberfläche um einen Winkel gedreht wird, der für eine Zahndickendifferenz relevant ist, sodass die tatsächliche Zahnoberfläche mit der theoretischen Zahnoberfläche an einem entsprechenden Gitterkoordinatenpunkt übereinstimmt und somit ein folgender Fehler $\varepsilon_{ij}$ zwischen der tatsächlichen Zahnoberfläche und der theoretischen Zahnoberfläche des archimedischen Schneckengetriebes erhalten wird:

$$\varepsilon_{ij} = (\mathbf{r}_{ij}^{(g)} - \mathbf{r}_{ij}^{(gl)}) \cdot \mathbf{n}_{ij} \qquad i = 1 \sim m, j = 1 \sim n$$

wobei $r_{ij}^{(g)}$ ein Koordinatenvektor der tatsächlichen Zahnoberfläche des archimedischen Schneckengetriebes an einem (i, j)-ten Gitterkoordinatenpunkt ist; $r_{ij}^{(gl)}$ ein theoretischer Vektor der tatsächlichen Zahnoberfläche des archimedischen Schneckengetriebes am (i, j)-ten Gitterkoordinatenpunkt ist; und $n_{ij}$ ein Normalenvektor der tatsächlichen Zahnoberfläche des archimedischen Schneckengetriebes am (i, j)-ten Gitterkoordinatenpunkt ist; und

2) Korrigieren eines Teilungsradiusinkrements $d_r$ des mit einem archimedischen Schneckengetriebe ausgebildeten Wälzfräsenwerkzeugs entsprechend dem Fehler $\varepsilon_{ij}$, und Festlegen:

$$d_r = \frac{\pm 4\Delta \cdot r_{pw}^{2}}{b_t^{2} \sin \alpha_n} \pm \varepsilon_{ij}$$

wobei $r_{pw}$ ein idealer Teilungsradius einer archimedischen Schnecke ist; $b_t$ eine Länge einer Längsachse einer Kontaktellipse an einem Mittelpunkt ist; $\alpha_n$ ein Quermodul des archimedischen Schneckengetriebes ist; und $\Delta$ ein umfassender Verformungskoeffizient eines Materials des mit einem archimedischen Schneckengetriebe ausgebildeten Wälzfräsenwerkzeugs ist; wodurch ein Durchmesserinkrement $\Delta_{os}$ des mit einem archimedischen Schneckengetriebe ausgebildeten Wälzfräsenwerkzeugs erhalten wird:

$$\Delta_{os} = (0{,}01 \sim 0{,}1) \times d_r$$

Korrigieren, gemäß dem Fehlers $\varepsilon_{ij}$ und dem Durchmesserinkrement $\Delta_{os}$, eines tatsächlichen Teilungs-

durchmessers $D_{ph}$ und eines tatsächlichen Spitzendurchmessers $D_{oh}$ des mit einem archimedischen Schneckengetriebe ausgebildeten Wälzfräsenwerkzeugs, jeweils umfassend:

$$D_{ph} = D_{pw} \pm 2\Delta_{os} \pm \varepsilon_{ij}$$

$$D_{oh} = D_{ph} \pm h_b$$

wobei $D_{pw}$ ein idealer Teilungsdurchmesser des mit einem archimedischen Schneckengetriebe ausgebildeten Wälzfräsenwerkzeugs ist; $D_{ph}$ ein korrigierter tatsächlicher Teilungsdurchmesser des mit einem archimedischen Schneckengetriebe ausgebildeten Wälzfräsenwerkzeugs ist; $h_b$ ein Abtastwert des archimedischen Schneckengetriebes ist; und $D_{oh}$ ein korrigierter tatsächlicher Spitzendurchmesser des mit einem archimedischen Schneckengetriebe ausgebildeten Wälzfräsenwerkzeugs ist;
wenn der tatsächliche Teilungsdurchmesser $D_{ph}$ des mit einem archimedischen Schneckengetriebe ausgebildeten Wälzfräsenwerkzeugs größer ist als der ideale Teilungsdurchmesser $D_{pw}$ der archimedischen Schnecke, dann:

$$D_{ph} = D_{pw} + 2\Delta_{os} + \varepsilon_{ij}$$

wenn der tatsächliche Teilungsdurchmesser $D_{ph}$ des mit einem archimedischen Schneckengetriebe ausgebildeten Wälzfräsenwerkzeugs kleiner ist als der ideale Teilungsdurchmesser $D_{pw}$ der archimedischen Schnecke, dann:

$$D_{ph} = D_{pw} - 2\Delta_{os} - \varepsilon_{ij}$$

wenn der tatsächliche Spitzendurchmesser $D_{oh}$ des mit einem archimedischen Schneckengetriebe ausgebildeten Wälzfräsenwerkzeugs größer ist als der ideale Spitzendurchmesser $D_{ph}$ des mit einem archimedischen Schneckengetriebe ausgebildeten Wälzfräsenwerkzeugs, dann:

$$D_{oh} = D_{ph} + h_b$$

und
wenn der tatsächliche Spitzendurchmesser $D_{oh}$ des mit einem archimedischen Schneckengetriebe ausgebildeten Wälzfräsenwerkzeugs kleiner ist als der ideale Spitzendurchmesser $D_{ph}$ des mit einem archimedischen Schneckengetriebe ausgebildeten Wälzfräsenwerkzeugs, dann:

$$D_{oh} = D_{ph} - h_b$$
;

und
Korrigieren eines Teilungswinkel $\lambda_{ph}$ mit dem korrigierten tatsächlichen Teilungsdurchmesser $D_{ph}$ des mit einem archimedischen Schneckengetriebe ausgebildeten Wälzfräsenwerkzeugs:

$$\lambda_{ph} = \arcsin \frac{m_a \pi N_w \cos \lambda_{pw}}{D_{ph}}$$

wobei $m_a$ ein Axialmodul der archimedischen Schnecke ist; $N_w$ die Anzahl der Gewindegänge der archimedischen Schnecke ist; und $\lambda_{pw}$ ein Steigungsanschnittwinkel der archimedischen Schnecke ist.

2. Verfahren nach Anspruch 1, wobei, wenn ein Ausdruck einer spiralförmigen Zahnoberfläche des mit einem archimedischen Schneckengetriebe ausgebildeten Wälzfräsenwerkzeugs $r^{(h)}(u, \theta)$ ist, ist die tatsächliche Zahnoberfläche $r^{(g)}$ des archimedischen Schneckengetriebes:

$$r^{(g)}(\varphi_g, u, \theta) = L_z(\varphi_g)[L_x(-\frac{\pi}{2} + \delta_t{}')L_z(-\varphi_h)r^{(h)}(u, \theta) + E_{hg}{}'\boldsymbol{i}]$$

$$f(\varphi_g, u, \theta) = \boldsymbol{n} \cdot \boldsymbol{v}^{(hg)} = 0$$

$$\varphi_g = \frac{N_g}{N_w}\varphi_h$$

wobei L eine 3*3-Rotationsmatrix ist und L einen Index als Rotationsachse und einen Parameter in einer Klammer als Rotationswinkel um die Rotationsachse annimmt; und wobei insbesondere $L_z(\varphi_g)$ eine 3*3-Rotationsmatrix ist, die einen Winkel von $\varphi_g$ um eine z-Achse dreht; $L_x(-\frac{\pi}{2} + \delta_t{}')$ eine Rotationsmatrix ist, die einen Winkel von $-\frac{\pi}{2} + \delta_t{}'$ um eine x-Achse dreht; $L_z(-\varphi_h)$ eine 3*3-Rotationsmatrix ist, die einen Winkel von $-\varphi_h$ um die z-Achse dreht; $\varphi_g$ und $\varphi_h$ jeweils ein Drehwinkel des archimedischen Schneckengetriebes und des mit einem archimedischen Schneckengetriebe ausgebildeten Wälzfräsenwerkzeugs sind; wobei $\delta_t{}'$ einen tatsächlichen Installationsabweichungswinkel des mit einem archimedischen Schneckengetriebe ausgebildeten Wälzfräsenwerkzeugs darstellt; $E_{hg}{}'$ einen tatsächlichen Installationsmittenabstand zwischen der Schnecke und dem Schneckengetriebe darstellt; i einen Normalenvektor einer Zahnoberfläche der Schnecke darstellt; $(u, \theta)$ ein Parameter der archimedischen spiralförmigen Zahnoberfläche ist; n eine Normalenlinie der spiralförmigen Zahnoberfläche des mit einem archimedischen Schneckengetriebe ausgebildeten Wälzfräsenwerkzeugs ist; $v^{(hg)}$ eine relative Geschwindigkeit zwischen dem mit einem archimedischen Schneckengetriebe ausgebildeten Wälzfräsenwerkzeug und der Zahnoberfläche des archimedischen Schneckengetriebes ist; und $N_w$ und $N_g$ jeweils die Anzahl der Gewindegänge der archimedischen Schnecke und die Anzahl der Zähne des archimedischen Schneckengetriebes sind; und
wenn das Durchmesserinkrement $\Delta_{os} = 0$ des mit einem archimedischen Schneckengetriebe ausgebildeten Wälzfräsenwerkzeugs ist, der Installationsabweichungswinkel des mit einem archimedischen Schneckenge-triebe ausgebildeten Wälzfräsenwerkzeugs $\delta_t{}' = 0$ ist und ein Bearbeitungsmittenabstand $E_{hg}{}' = E_{wg}$ ist, erhält man die theoretische Zahnoberfläche $r^{(gl)}$ des archimedischen Schneckengetriebes; und die Zahnoberfläche des archimedischen Schneckengetriebes wird in Koordinatenpunkte unterteilt, und eine Formel zum Auswählen von m $\times$ n Gitterkoordinatenpunkten ist:

$$r^{(g)}(\varphi_g, u, \theta)f(\varphi_g, u, \theta) = \boldsymbol{n} \cdot \boldsymbol{v}^{(hg)} = 0$$

$$z_{ij}^{(g)} - 0.5F_w{}' + (i-1)\frac{F_w{}'}{m-1} = 0 \qquad i = 1 \sim m$$

$$\sqrt{(x_{ij}^h)^2 + (y_{ij}^h)^2} - R_a + (j-1)\frac{h_w}{n-1} = 0 \qquad j = 1 \sim n$$

wobei $z_{ij}^{(g)}$ eine Koordinate der Zahnoberfläche des archimedischen Schneckengetriebes entlang der Rotationsachse z ist; $F_w{}'$ eine effektive Stirnbreite des archimedischen Schneckengetriebes ist; ($x_{ij}^h$, $y_{ij}^h$) eine Koordinate des mit einem archimedischen Schneckengetriebe ausgebildeten Wälzfräsenwerkzeugs am (i,j)-ten Gitterkoordinatenpunkt ist; $R_a$ und $h_w$ ein Spitzenradius und eine Arbeitstiefe der archimedischen Schnecke sind; und $E_{wg}$ ein idealer Installationsmittenabstand zwischen der Schnecke und dem Schneckengetriebe ist.

3. Verfahren nach Anspruch 1 oder 2, wobei der umfassende Verformungskoeffizient $\Delta$ des Materials des mit einem archimedischen Schneckengetriebe ausgebildeten Wälzfräsenwerkzeugs in eine stückweise Funktion entspre-

chend dem Modul $m_a$ der archimedischen Schnecke unterteilt wird, insbesondere:

wenn die Umgebungstemperatur 20-25 °C beträgt und das Modul $m_a$ der archimedischen Schnecke 1-6 mm $\Delta$ = 0,005 mm beträgt;
wenn die Umgebungstemperatur 20-25 °C beträgt und das Modul $m_a$ der archimedischen Schnecke 6-12 mm, $\Delta$ = 0,010 mm beträgt; und
wenn die Umgebungstemperatur 20-25 °C beträgt und das Modul $m_a$ der archimedischen Schnecke 12-15 mm, $\Delta$ = 0,015 mm beträgt.

4. Verfahren nach einem vorstehenden Anspruch, wobei das Durchmesserinkrement $\Delta_{os}$ des mit einem archimedischen Schneckengetriebe ausgebildeten Wälzfräsenwerkzeugs in eine stückweise Funktion entsprechend dem Modul $m_a$ der archimedischen Schnecke unterteilt wird, insbesondere:

wenn das Modul $m_a$ der archimedischen Schnecke 1-6 mm, $\Delta_{os} = (0,01 - 0,02) \times d_r$ beträgt;
wenn das Modul $m_a$ der archimedischen Schnecke 6-12 mm, $\Delta_{os} = (0,01 - 0,03) \times d_r$ beträgt; und
wenn das Modul $m_a$ der archimedischen Schnecke 12-15 mm, $\Delta_{os} = (0,04 - 0,05) \times d_r$ beträgt.

5. Verfahren nach einem vorstehenden Anspruch, weiter umfassend: zum Konfigurieren einer Schneckengetriebemaschine, Einstellen eines Installationsabweichungswinkels $\delta^a_t$ des archimedischen Wälzfräsenwerkzeugs auf einer Schneckengetriebemaschine als:

$$\delta_t^a = \lambda_{pw} - \lambda_{ph}$$

und

Einstellen der Schneckengetriebemaschine, sodass ein tatsächlicher Bearbeitungsmittenabstand $E^a_{hg}$ zwischen einem Schneckengetriebe und einer Schnecke ist:

$$E_{hg}^a = E_{wg} + 0,5\Delta_{os}$$

wobei $\lambda_{pw}$ ein idealer Steigungsanschnittwinkel der archimedischen Schnecke ist; $\lambda_{ph}$ ein korrigierter Steigungsanschnittwinkel des mit einem archimedischen Schneckengetriebe ausgebildeten Wälzfräsenwerkzeugs ist; $E_{wg}$ ein idealer Installationsmittenabstand zwischen der Schnecke und dem Schneckengetriebe ist; und $\Delta_{os}$ ein Durchmesserinkrement des mit einem archimedischen Schneckengetriebe ausgebildeten Wälzfräsenwerkzeugs ist.

**Revendications**

1. Procédé de conception d'une fraise à engrenage à vis sans fin d'Archimède, comprenant les étapes suivantes :

1) l'acquisition d'une erreur $\varepsilon_{ij}$ entre une surface de dent réelle et une surface de dent théorique d'un engrenage à vis sans fin d'Archimède,

comme une épaisseur de dent théorique de l'engrenage à vis sans fin d'Archimède est différente d'une épaisseur de dent réelle d'un engrenage à vis sans fin de fraisage, avant le calcul de l'erreur $\varepsilon_{ij}$ entre la surface de dent réelle et la surface de dent théorique de l'engrenage à vis sans fin d'Archimède, la surface réelle de dent tourne selon un angle pertinent pour une différence d'épaisseur de dent,
de sorte que la surface de dent réelle coïncide avec la surface de dent théorique au niveau d'un point de coordonnées de grille correspondant, et une erreur $\varepsilon_{ij}$ suivante entre la surface de dent réelle et la surface de dent théorique de l'engrenage à vis sans fin d'Archimède est obtenue :

$$\varepsilon_{ij} = (r_{ij}^{(g)} - r_{ij}^{(gl)}) \cdot n_{ij} \qquad i = 1 \sim m, \, j = 1 \sim n$$

dans lequel, $r_{ij}^{(g)}$ est un vecteur de coordonnées de la surface de dent réelle de l'engrenage à vis sans fin d'Archimède au niveau d'un $(i, j)$ème point de coordonnées de grille ; $r_{ij}^{(gl)}$ est un vecteur théorique de la surface de dent réelle de l'engrenage à vis sans fin d'Archimède au niveau du (i, j) ème point de coordonnées de grille ; et $n_{ij}$ est un vecteur normal de la surface de dent réelle de la vis sans fin d'Archimède au niveau du (i, j)ème point de coordonnées de grille ; et

2) la correction d'un incrément de rayon de pas $d_r$ de la fraise à engrenage à vis sans fin d'Archimède selon l'erreur $\varepsilon_{ij}$, et le réglage :

$$d_r = \frac{\pm 4\Delta \cdot r_{pw}^{\;2}}{b_t^{\;2} \sin \alpha_n} \pm \varepsilon_{ij}$$

dans lequel, $r_{pw}$ est un rayon de pas idéal d'une vis sans fin d'Archimède ; $b_t$ est une longueur d'un axe long d'une ellipse de contact au niveau d'un point médian ; $\alpha_n$ est un module transversal de l'engrenage à vis sans fin d'Archimède ; et $\Delta$ est un coefficient de déformation global d'un matériau de la fraise à engrenage à vis sans fin d'Archimède ;

l'obtention par conséquent d'un incrément de diamètre $\Delta_{os}$ de la fraise à engrenage à vis sans fin d'Archimède :

$$\Delta_{os} = (0,01 \sim 0,1) \times d_r$$

la correction, selon l'erreur $\varepsilon_{ij}$ et l'incrément de diamètre $\Delta_{os}$, d'un diamètre de pas réel $D_{ph}$ et d'un diamètre de pointe réel $D_{oh}$ de la fraise à engrenage à vis sans fin d'Archimède, comprenant respectivement :

$$D_{ph} = D_{pw} \pm 2\Delta_{os} \pm \varepsilon_{ij}$$

$$D_{oh} = D_{ph} \pm h_b$$

dans lequel, $D_{pw}$ est un diamètre de pas idéal de la vis sans fin d'Archimède ; $D_{pn}$ est un diamètre de pas réel corrigé de la fraise à engrenage à vis sans fin d'Archimède ; $h_b$ est un dedendum de l'engrenage à vis sans fin d'Archimède ; et $D_{oh}$ est un diamètre de pointe réel corrigé de la fraise à engrenage à vis sans fin d'Archimède ;

si le diamètre de pas réel $D_{ph}$ de la fraise à vis sans fin d'Archimède est supérieur au diamètre de pas idéal $D_{pw}$ de la vis sans fin d'Archimède, alors :

$$D_{ph} = D_{pw} + 2\Delta_{os} + \varepsilon_{ij}$$

si le diamètre de pas réel $D_{ph}$ de la fraise à engrenage à vis sans fin d'Archimède est inférieur au diamètre de pas idéal $D_{pw}$ de la vis sans fin d'Archimède, alors :

$$D_{ph} = D_{pw} - 2\Delta_{os} - \varepsilon_{ij}$$

si le diamètre de pointe réel $D_{oh}$ de la fraise à engrenage à vis sans fin d'Archimède est supérieur au diamètre de point idéal $D_{ph}$ de la fraise à engrenage à vis sans fin d'Archimède, alors :

$$D_{oh} = D_{ph} + h_b$$

et

si le diamètre de pointe réel $D_{oh}$ de la fraise à engrenage à vis sans fin d'Archimède est inférieur au diamètre de pointe idéal $D_{ph}$ de la fraise à engrenage à vis sans fin d'Archimède, alors :

$$D_{oh} = D_{ph} - h_b \; ,$$

et

la correction d'un angle d'attaque de pas $\lambda_{ph}$ avec le diamètre de pas variable réel corrigé $D_{ph}$ de la fraise à engrenage à vis sans fin d'Archimède :

$$\lambda_{ph} = \arcsin \frac{m_a \pi N_w \cos \lambda_{pw}}{D_{ph}}$$

dans lequel, $m_a$ est un module axial de la vis sans fin d'Archimède ; $N_w$ est le nombre de filetages de la vis sans fin d'Archimède ; et $\lambda_{pw}$ est un angle d'attaque de pas de la vis sans fin d'Archimède.

2. Procédé selon la revendication 1, dans lequel si on laisse une expression d'une surface de dent hélicoïdale de la fraise à engrenage à vis sans fin d'Archimède être $r^{(h)}(u, \theta)$, alors la surface de dent réelle $r^{(g)}$ de l'engrenage à vis sans fin d'Archimède est :

$$r^{(g)}(\varphi_g, u, \theta) = L_z(\varphi_g)[L_x(-\frac{\pi}{2} + \delta_t')L_z(-\varphi_h)r^{(h)}(u, \theta) + E_{hg}'i]$$

$$f(\varphi_g, u, \theta) = n \cdot v^{(hg)} = 0$$

$$\varphi_g = \frac{N_g}{N_w} \varphi_h$$

dans lequel $L$ est une matrice de rotation 3*3, et $L$ prend un indice comme axe de rotation et un paramètre entre parenthèses comme angle de rotation autour de l'axe de rotation ; et spécifiquement, $L_z(\varphi_g)$ est une matrice de rotation 3*3 tournant sur un angle de $\varphi_g$ autour d'un axe z ; $L_x(-\frac{\pi}{2} + \delta_t')$ est une matrice de rotation tournant sur un angle $-\frac{\pi}{2} + \delta_t'$ autour d'un axe $x$ ; $L_z(-\varphi_h)$ est une matrice de rotation 3*3 tournant sur un angle de $-\varphi_h$ autour de l'axe z ; $\varphi_g$ et $\varphi_h$ sont respectivement un angle de rotation de l'engrenage à vis sans fin d'Archimède et de la fraise à engrenage à vis sans fin d'Archimède ; $\delta_t'$ représente un angle d'écart d'installation réel de la fraise à engrenage à vis sans fin d'Archimède ; $E_{hg}'$ représente une distance de centre d'installation réelle entre la vis sans fin et l'engrenage à vis sans fin ; i représente un vecteur normal d'une surface de dent de la vis sans fin ; (u, θ) est un paramètre de la surface de dent hélicoïdale d'Archimède ; $n$ est une ligne normale de la surface de dent hélicoïdale de la fraise à engrenage à vis sans fin d'Archimède ; $v^{(hg)}$ est une vitesse relative entre la fraise à engrenage à vis sans fin d'Archimède et la surface de dent de la vis sans fin d'Archimède ; et $N_w$ et $N_g$ sont respectivement le nombre de filetages de la vis sans fin d'Archimède et le nombre de dents de l'engrenage à vis sans fin d'Archimède ; et
en laissant l'incrément de diamètre $\Delta_{os} = 0$ de la fraise à engrenage à vis sans fin d'Archimède, l'angle d'écart d'installation $\delta_t' = 0$ de la fraise à engrenage à vis sans fin d'Archimède et une distance de centre d'usinage $E_{hg}' = E_{wg}$, la surface de dent théorique $r^{(gl)}$ de l'engrenage à vis sans fin d'Archimède est obtenue ; et la surface de dent de la vis sans fin d'Archimède est quadrillée en points de coordonnées, et une formule pour sélectionner m $\times$ n points de coordonnées de grille est :

$$r^{(g)}(\varphi_g, u, \theta)f(\varphi_g, u, \theta) = n \cdot v^{(hg)} = 0$$

$$z_{ij}^{(g)} - 0.5F_w' + (i-1)\frac{F_w'}{m-1} = 0 \qquad i = 1 \sim m$$

$$\sqrt{(x_{ij}^h)^2 + (y_{ij}^h)^2} - R_a + (j-1)\frac{h_w}{n-1} = 0 \qquad j = 1 \sim n$$

dans laquelle, $z_{ij}^{(g)}$ est une coordonnée de la surface de dent de l'engrenage à vis sans fin d'Archimède le long de l'axe de rotation z ; $F_w'$ est une largeur de face effective de la vis sans fin d'Archimède ; ($x_{ij}^h$, $y_{ij}^h$) est une coordonnée de la fraise à engrenage à vis sans fin d'Archimède au niveau du (i, j)ème point de coordonnées de grille ; $R_a$ et $h_w$ sont un rayon de pointe et une profondeur de travail de la vis sans fin d'Archimède ; et $E_{wg}$ est une distance de centre d'installation idéale entre la vis sans fin et l'engrenage à vis sans fin.

**3.** Procédé selon la revendication 1 ou la revendication 2, dans lequel le coefficient de déformation global $\Delta$ du matériau de la fraise à engrenage à vis sans fin d'Archimède est divisé en une fonction par pièces selon le module $m_a$ de la vis sans fin d'Archimède, spécifiquement :

lorsque la température ambiante est de 20 à 25 °C et que le module $m_a$ de la vis sans fin d'Archimède est de 1 à 6 mm $\Delta$ = 0,005 mm ;
lorsque la température ambiante est de 20 à 25 °C et que le module $m_a$ de la vis sans fin d'Archimède est de 6 à 12 mm, $\Delta$ = 0,010 mm ;
lorsque la température ambiante est de 20 à 25 °C et que le module $m_a$ de la vis sans fin d'Archimède est de 12 à 15 mm, $\Delta$ = 0,015 mm

**4.** Procédé selon une quelconque revendication précédente, dans lequel l'incrément de diamètre $\Delta_{os}$ de la fraise à engrenage à vis sans fin d'Archimède est divisé en une fonction par pièces selon le module $m_a$ de la vis sans fin d'Archimède, spécifiquement :

lorsque le module $m_a$ de la vis sans fin d'Archimède est de 1 à 6 mm, $\Delta_{os}$ = (0,01 ~ 0,02) $\times$ $d_r$.
lorsque le module $m_a$ de la vis sans fin d'Archimède est de 6 à 12 mm, $\Delta_{os}$ = (0,01 ~ 0,03) $\times$ $d_r$ et
lorsque le module $m_a$ de la vis sans fin d'Archimède est de 12 à 15 mm, $\Delta_{os}$ = (0,04 -0,05) $\times$ $d_r$.

**5.** Procédé selon une quelconque revendication précédente, comprenant en outre : pour configurer une machine à engrenage à vis sans fin, le réglage d'un angle d'écart d'installation $\delta^a_t$ de la fraise d'Archimède sur une machine à engrenage à vis sans fin comme suit :

$$\delta_t^a = \lambda_{pw} - \lambda_{ph}$$

et

le réglage de la machine à engrenage à vis sans fin de sorte qu'une distance de centre d'usinage réelle $E^a_{hg}$ entre un engrenage à vis sans fin et une vis sans fin soit :

$$E_{hg}^a = E_{wg} + 0,5\Delta_{os}$$

dans laquelle, $\lambda_{pw}$ est un angle d'attaque de pas idéal de la vis sans fin d'Archimède ; $\lambda_{ph}$ est un angle d'attaque de pas corrigé de la fraise à engrenage à vis sans fin d'Archimède ; $E_{wg}$ est une distance de centre d'installation idéale entre la vis sans fin et l'engrenage à vis sans fin ; et $\Delta_{os}$ est un incrément de diamètre de la fraise à engrenage à vis sans fin d'Archimède.

FIG. 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 109376448 A